(19) **Europäisches Patentamt**
**European Patent Office**
**Office européen des brevets**

(11) **EP 3 521 836 B1**

(12) **EUROPEAN PATENT SPECIFICATION**

(45) Date of publication and mention
of the grant of the patent:
**02.08.2023 Bulletin 2023/31**

(51) International Patent Classification (IPC):
**G01R 13/34** (2006.01)    **G01R 19/25** (2006.01)
**G01R 19/00** (2006.01)    **H03H 15/00** (2006.01)

(21) Application number: **19155624.0**

(22) Date of filing: **05.02.2019**

(52) Cooperative Patent Classification (CPC):
**G01R 13/34; G01R 19/0053; G01R 19/2509**

(54) **PASSIVE VARIABLE CONTINUOUS TIME LINEAR EQUALIZER WITH ATTENUATION AND FREQUENCY CONTROL**

PASSIVER VARIABLER KONTINUIERLICHER ZEITLINEARER ENTZERRER MIT DÄMPFUNG UND FREQUENZREGELUNG

ÉGALISEUR LINÉAIRE À TEMPS CONTINU VARIABLE PASSIF À COMMANDE D'ATTÉNUATION ET DE FRÉQUENCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.02.2018 US 201862626622 P**
         **29.08.2018 US 201816116677**

(43) Date of publication of application:
**07.08.2019 Bulletin 2019/32**

(73) Proprietor: **Tektronix, Inc.**
**Beaverton, OR 97077-0001 (US)**

(72) Inventors:
• **PICKERD, John**
**Hillsboro, OR 97123 (US)**
• **TAN, Kan**
**Portland, OR 97229 (US)**
• **HOJABRI, Pirooz**
**San Jose, CA 95120 (US)**

(74) Representative: **HGF**
**HGF Limited**
**1 City Walk**
**Leeds LS11 9DX (GB)**

(56) References cited:
WO-A1-2015/048678    WO-A2-2015/021481
JP-A- H0 290 871    US-A- 4 727 424
US-A- 4 953 026    US-A- 5 220 163
US-A- 6 085 104    US-A1- 2006 080 065
US-A1- 2006 133 599    US-A1- 2007 064 923
US-A1- 2008 123 756    US-A1- 2009 002 213
US-A1- 2010 007 419    US-A1- 2014 072 025
US-A1- 2014 348 018    US-A1- 2015 104 191
US-A1- 2017 054 469

• SU HAN ET AL: "A digitally assisted analog cancellation system at RF frequencies for improving the isolation performance of a ceramic duplexer", 2016 46TH EUROPEAN MICROWAVE CONFERENCE (EUMC), EUROPEAN MICROWAVE ASSOCIATION, 4 October 2016 (2016-10-04), pages 61-64, XP033045307, DOI: 10.1109/EUMC.2016.7824277 [retrieved on 2017-01-18]
• RIZA N A ET AL: "MICROMECHANICS-BASED WAVELENGTH-SENSITIVE PHOTONIC BEAM CONTROL ARCHITECTURES AND APPLICATIONS", APPLIED OPTICS, OPTICAL SOCIETY OF AMERICA, WASHINGTON, DC; US, vol. 39, no. 6, 20 February 2000 (2000-02-20), pages 919-932, XP000928331, ISSN: 0003-6935, DOI: 10.1364/AO.39.000919

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

PRIORITY

FIELD OF THE INVENTION

This disclosure is directed to systems and methods associated with aspects of a test and measurement system, and, more particularly, to systems and methods for controlling noise and frequency attenuation in the test and measurement system.

BACKGROUND

Test and measurement systems are designed to receive signal inputs, e.g., from a Device Under Test (DUT), sample the signals, and display the result as a waveform. An input channel of the test and measurement system can add noise to the signal from the DUT. Sometimes, individualized fixed passive noise filters can be built to filter out the added noise to the signal by test and measurement system. However, the noise filters depend on the channel characteristic of the test and measurement instrument as well as the type of signal received from the DUT. For the individualized fixed noise filters to be beneficial, a user would need a number of various fixed noise filters on hand to best match the loss and the data rate of the channel being used to test the DUT. These various different fixed noise filters are expensive and it can be difficult to keep track of which noise filter is needed for a given test situation.

Some active noise filters are programmable and may be used in place of the individualized fixed passive noise filters. However, these programmable active noise filters often create too much noise to be useful in a large variety of situations. Further, the bandwidth of these programmable active noise filters is often not extendable up to higher bandwidths, such as 70GHz. What is needed is a wide bandwidth noise filter that minimizes the use of a number of components, as well as maximizes the bandwidth that can be achieved. US2009/002213 and US2006/080065 teach high speed oscilloscope front-ends that split up the incoming analog signal and frequency convert it before digitizing it using a plurality of ADC's, the digital outputs of which are subsequently recombined.

Passive Continuous Time Linear Equalizers (CTLEs) have been used in serial data systems as a means of improving Signal-to-Noise (SNR) ratios and in performing pseudo de-embedding in lossy systems so that clock recovery in the receiver can function well.

Although some programmable CTLEs have been developed with some success, such devices use active circuitry and create too much noise to be very useful in many situations. In addition, the bandwidth of programmable CLTEs is not extendable up to, or beyond, the current 70GHz channels that are in use with current generation oscilloscopes.

Embodiments of the disclosure address these and other deficiencies of the prior art.

BRIEF DESCRIPTION OF THE DRAWINGS

Aspects, features and advantages of embodiments of the present disclosure will become apparent from the following description of embodiments in reference to the appended drawings in which:

Fig. 1 is an example block diagram of a noise filter having a variable attenuator and/or a variable delay line according to some embodiments of the disclosure.

Fig. 2 is another example block diagram of a noise filter having a variable attenuator and/or a variable delay line according to other embodiments of the disclosure.

Fig. 3 is another example block diagram of a noise filter with a multiplexer to split an input signal into a high frequency band signal a low frequency band signal, the noise filter also including a variable attenuator and/or a variable delay line according to other embodiments of the disclosure.

Fig. 4 is another example block diagram of a noise filter for a differential signal using cross-coupling of the positive and negative signals according to other embodiments of the disclosure.

Fig. 5 is another example block diagram of a noise filter for a differential signal without cross-coupling according to other embodiments of the disclosure.

Fig. 6 is another example block diagram of a noise filter for a differential signal having multiplexers to split a positive input signal and a negative input signal into high frequency band signal a low frequency band signal.

Fig. 7 illustrates an example of a passive variable CTLE circuit in accordance with certain embodiments of the disclosed technology.

Fig. 8 illustrates an implementation of a variable CTLE that uses stepped control of the CTLE response in accordance with certain embodiments of the disclosed technology.

Fig. 9 illustrates an implementation where the balun of FIGURE 7 is replaced by an active differential amplifier in accordance with certain embodiments of the disclosed technology.

Fig. 10 and Fig. 11 illustrate embodiments of the invention that use diplexers in accordance with certain embodiments of the disclosed technology.

Fig. 12 illustrates an example of a variable CTLE circuit using a four-branch architecture in accordance with certain embodiments of the disclosed technology.

Fig. 13 illustrates an example of another variable CTLE circuit in accordance with certain embodiments of the disclosed technology.

Fig. 14 illustrates an example of yet another variable CTLE circuit in accordance with certain embodiments of the disclosed technology.

Fig. 15 to Fig. 18 illustrate CTLE responses for different delays and attenuations.

DESCRIPTION

Disclosed herein is a continuously or step variable passive noise filter for removing noise from a signal received from a DUT added by a test and measurement instrument channel. The noise filter may include, for example, a splitter configured to split a signal into at least a first split signal and a second split signal, each of the first and second split signals. A first path receives the first split signal and includes a variable attenuator and/or a variable delay line which may be set based on the test and measurement instrument channel with which the DUT is connected. The variable attenuator and/or the variable delay line may be continuous or stepped, as will be discussed in more detail below. A second path is also included to receive the second split signal and a combiner combines a signal from the first path and a signal from the second path into a combined signal.

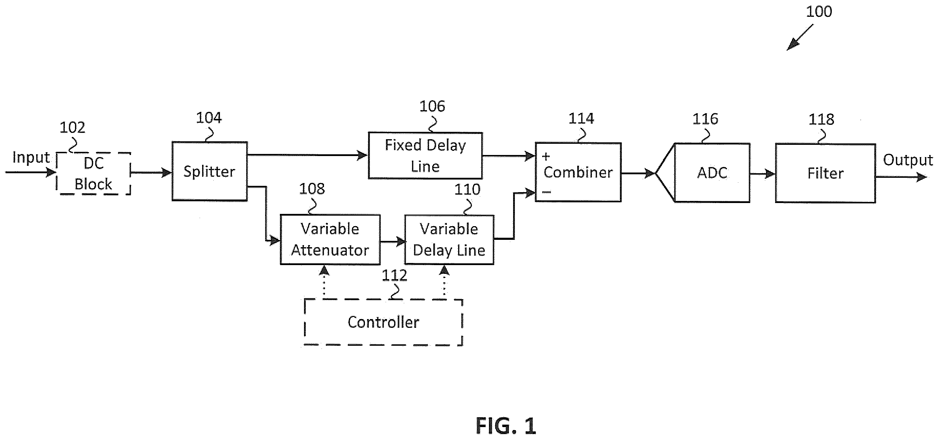

The second path may include a fixed delay line and can, in some instances, be a reference signal. The signal in the first path is delayed and attenuated to adjust for the noise added by the test and measurement instrument, and then the signal in the first path is subtracted from the reference signal on the second path to determine the input signal without the added noise of the test and measurement instrument channel. Various embodiments of such a noise filter are discussed below with respect to Figs. 1-6.

Embodiments of the disclosures provide an improvement by reducing noise in the test and measurement instrument, as well as allowing a test and measurement instrument channel to have a frequency response with a continuous time linear equalizer (CTLE) shape response. The reduction in noise can be achieved without keeping a plurality of different CTLE filters on hand and having to replace the filters based on a specific test situation - rather, the variable attenuator and/or the variable delay line can be programmed or set based on the needs of the test. Embodiments of the disclosure are also able to be implemented in high frequency bandwidths, such as 70GHz or above.

Fig. 1 illustrates a block diagram of an example noise filter 100 according to some embodiments of the disclosure. The noise filter 100 may be, for example, a CTLE filter. The noise filter 100 includes an optional direct current (DC) block 102 configured to receive an input signal, such as a signal from a device under test (not shown). The DC block 102 can be configured, for example, to allow radio frequency (RF) signals to pass through while blocking audio and DC frequency interference. The noise filter 100 includes a splitter 104 to receive an output from the DC block 102, or the input signal if DC Block 102 is omitted. The splitter 104 may be, for example, a Wilkinson splitter, which has 3 decibels (dB) of signal loss. However, embodiments of the disclosure are not limited to such a splitter, but may include any splitter that splits the signal into split signals. In some instances, the splitter can be configured to split the signal such that each split signal substantially includes the entire bandwidth of the input signal. For example, another type of splitter that may be used is a three-resistor power splitter or a multiplexer.

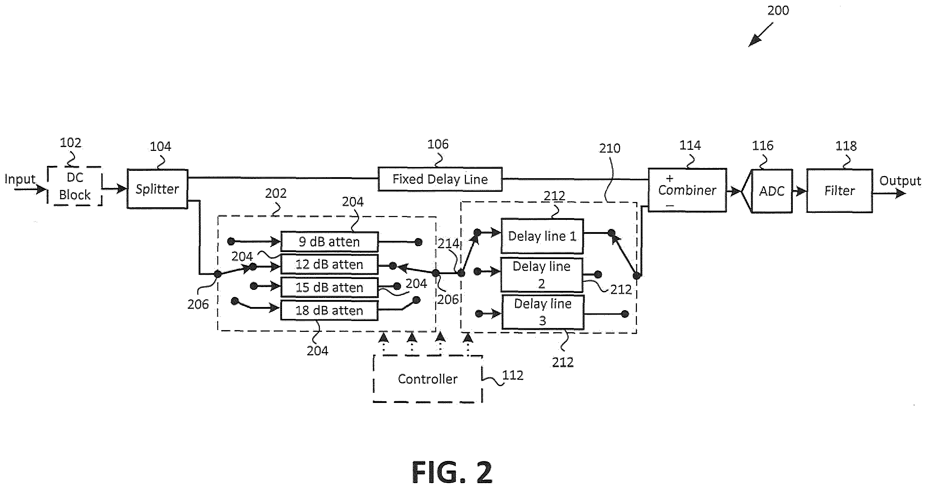

The output of the splitter 104 is provided to two signal paths. The first signal path includes a fixed delay line 106. The second signal path includes a variable attenuator 108 and a variable delay line 110. In this example embodiment, the variable attenuator 108 and the variable delay line 110 are continuously variable. Although both the attenuator 108 and the delay line 110 are shown as continuously variable, embodiments are not limited to such a combination. Rather, only one of the attenuator 108 and the delay 110 may be viable. Other variations will be discussed in more detail below with respect to Figs. 2-6. Further, embodiments are not limited to the signal in the second signal path being attenuated by the attenuator 108 prior to being delayed by the delay line 110. As will be understood by one skilled in the art, in some embodiments, although not shown, the signal in the second signal path may be delayed through delay line 110 prior to being attenuated by attenuator 108.

The variable attenuator 108 and/or the variable delay line 110 may be adjusted manually or by a controller 112. The controller 112 is illustrated but embodiments of the disclosure are not limited to this implementation. Rather, the variable attenuator 108 and/or the variable delay line 110 may be adjusted manually by a user.

The variable attenuator 108 may control the difference in magnitude in dB between the low frequencies and the high frequencies. Adjusting the variable attenuator 108 does not move the pole location of the overall noise filter 100. That is, the attenuator 108 only changes the height of the frequency response peak without moving it in frequency.

As such, it may be adjusted to accommodate different DUT channel loss for a given data rate. The variable delay line 110, on the other hand, moves the pole location of the noise filter 100 in frequency without changing the range of magnitude between the high and low frequencies. As such, the variable delay line 110 can be adjusted to accommodate different data rate signals. That is, the variable attenuator 108 or the variable delay line 110 can be adjusted either manually or by a controller based on which channel of the test and measurement instrument a signal from the DUT is received so that any noise added by that channel may be removed. For example, as will be discussed in more detail below, a user can determine a desired attenuation amount and/or delay amount and set the settings for the variable attenuator 108 or change the delay line 110 lengths to the desired amounts. In other embodiments, a user may be able to set the desired amounts on the test and measurement instrument, which then transmits instructions to the controller to adjust the variable attenuator 108 and/or the variable delay line 110. Further, in some embodiments, the test and measurement instrument may have specific attenuation amounts and/or delay saved in a memory with respect to each channel of the test and measurement instrument and may instruct the controller based on which channel the DUT is connected.

A combiner 114 receives a signal from both the first signal path and the second signal path and combines the two signals together to obtain a negative branch summation. The combiner 114 should either subtract the signals from the first signal path and the signal second path or combine the signals from the first signal path and the second signal path when one path is inverted to accomplish the negative branch summation. For example, in some embodiments, the combiner 114 may be a balun, which includes an inverted input and a non-inverted input, which provides a desired shape for the noise filter frequency response. In some embodiments, the balun may be a 6 dB loss balun. As another example, in some embodiments the combiner 114 may be an active differential amplifier, which is able to operate all the way to zero frequency as well as provide gain.

The combined signal is converted from an analog signal to a digital signal through an analog-to-digital converter 116. The digital signal may be saved in a memory or processed further in the test and measurement instrument. Further, a filter 118 is provided in the noise filter 100, which may be a lowpass filter, a de-embed filter, and/or a reshaping filter, to filter the digital signal further prior to being either stored in a memory or further processed through a test and measurement system, such as an oscilloscope (not shown). A lowpass filter, if used, can limit the bandwidth of the digitized signal to only include the first slope and peak of the digital signal. For example, the noise filter 100 response may be sinusoidal in shape, and only the first slope is used. A de-embed filter, if used, can reshape the frequency response of the test and measurement instrument channel back to a flat response. In so doing, the noise introduced by the noise filter 100 will be reduced without reducing the noise of the DUT. Finally, the attenuator 108 and/or delay line 110 can be adjusted so that the output of the noise filter 100 is as close to the desired response as possible. If a reshaping filter is used, the reshaping filter then further reshapes the output to be the desired response. The reshaping filter may be used, for example, whenever a test and measurement instrument channel is required to have a frequency response with a specific industry standard CTLE shape response.

The output of the ADC 116 or the filter 118 is substantially similar to the input signal, but a varying frequency attenuation caused by test and measurement instrument channel has been removed by combining through the combiner 114 the signal in the first path that is delayed and attenuated based on the channel of the test and instrument measurement to which the DUT is connected, and the signal on the second path, which is delayed by a known fixed delay.

Fig. 2 illustrates a block diagram of another example noise filter 200 according to some embodiments of the disclosure. Similar to Fig. 1, the noise filter 200 may include a DC block 102. The filter includes a splitter 104, a fixed delay 106, a combiner 114, an ADC 116, and a filter 118, similar to those and their variations discussed above. As such, these components are not described again in detail with respect to Fig. 2. The noise filter 200, as discussed below, provides stepped control of the noise filter frequency response, rather than a continuous control like the noise filter 100 of Fig. 1.

The noise filter 200 of Fig. 2 also includes a variable attenuator 202 and/or a variable delay line 210, similar to Fig. 1. However, one or both of the variable attenuator 202 and/or the variable delay line 210 is composed of a number of fixed components that can be switched into or out of the second signal path.

For example, the variable attenuator 202 may include a number of fixed attenuators 204 that vary the attenuation amount. Although the fixed attenuators 204 list various attenuation amounts, such is shown only for illustration and it will be understood by one skilled in the art that the disclosure is not limited to these specific fixed attenuator amounts. Rather, the fixed attenuators 204 may have attenuation amounts different from those illustrated in Fig. 2. A single pole multi throw switch 206 may be provided to switch a selected attenuation amount to the second signal path. The switch may be switched may be switched manually by a user or may be operated by a controller 112.

In some embodiments, the variable delay line 210 may also include a number of fixed delay lines 212 that vary the delay amount. A single pole multi throw switch 214 may be provided to switch a selected delay amount to the second signal path. Similar to the variable attenuator 202, the switch may be switched manually by a user or may be operated by the controller 112. In some embodiments, a separate controller 112 may be provided for each of the variable attenuator 202 and the variable delay line 210.

Although Fig. 2 illustrates both the variable attenuator 202 and the variable delay line 210 including a plurality of fixed components and switches, in some embodiments, as will be appreciated by one skilled in the art, only one of the attenuator 200 and the delay line 210 includes the fixed components and the switches, while the other is either a single fixed component or is a variable attenuator 108 or variable delay line 110 discussed above. That is, the variable attenuators 108 and 200 and the variable delay lines 110 and 210 may be provided any combination, including one of the attenuators 108 and 200 or the delay lines 110 and 210 being fixed.

In the embodiment illustrated in Fig. 2, twelve possible frequency response settings are provided based on the four fixed attenuators 204 and the three fixed delay lines 212. However, embodiments are not limited to such an implementation. Rather, any number of fixed attenuators 204 may be present and switched into the second signal path, as well as any number of fixed delay lines 212.

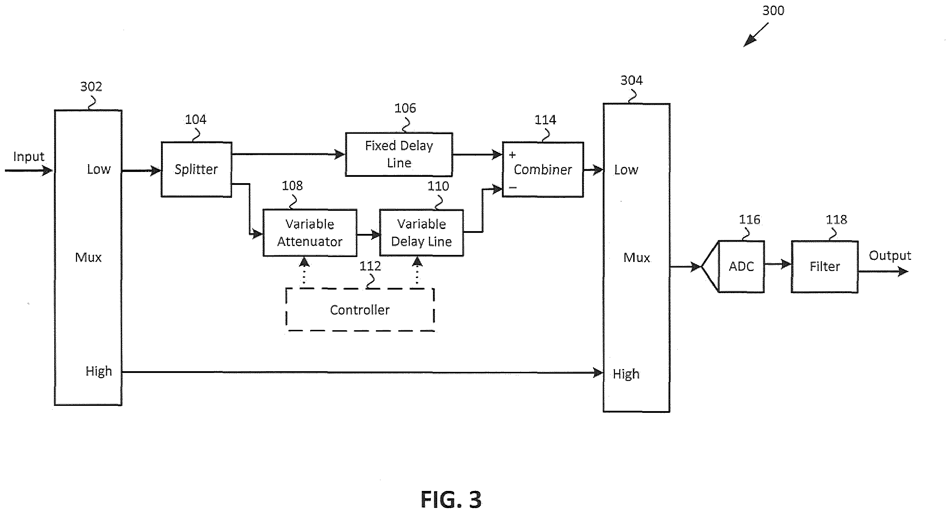

Fig. 3 illustrates another example noise filter 300 according to embodiments of the disclosure. Similar to Figs. 1 and 2, the noise filter 300 includes a splitter 104, a fixed delay 106, a controller 112, a combiner 114, an ADC 116, and a filter 118, similar to those and their variations discussed above. As such, these components are not described again in detail with respect to Fig. 3.

Noise filter 300 may include a multiplexer 302 to receive an input signal from a DUT. The multiplexer 302 is a passive device that implements frequency domain multiplexing. The multiplexer 302 may convert a signal, such as input signal, with a broad range of frequencies into two or more signal bands with mutually exclusive frequency ranges. A multiplexer 302 that converts a signal into two frequency bands may be referred to as a diplexer, a multiplexer that converts a signal into three frequency bands may be referred to as a triplexer, etc. For example, the multiplexer 302 is configured to separate the input signal into a plurality of frequency bands including a high frequency band and a low frequency band. The high frequency band and the low frequency band may then be forwarded along a high frequency channel and a low frequency channel, respectively.

The low frequency band may be received at the splitter 102, similar to Figs. 1 and 2 discussed above. In the embodiment illustrated in Fig. 3, a variable attenuator 108 and a variable delay line 110 are shown in the second signal path. However, embodiments of the disclosure are not limited to this implementation. As will be understood by one skilled in the art, the variable attenuator 202 and/or the variable delay line 210 may be provided in the second signal path, similar to the embodiment shown in Fig. 2. Further, only one variable attenuator 108 or 202 or variable delay line 110 or 210 may be provided while the other component is fixed.

The combined signal from the combiner 114 is received at a multiplexer 304, which acts as a combiner to combine the low frequency band and the high frequency band together into a full bandwidth signal that is converted by the ADC 116 and filtered by filter 118.

The multiplexers 302 and 304 have a lower loss than splitter 102. For example, in the low frequency band, the multiplexers 302 and 304 have a few tenths of a decibel of loss and in the high band may have 1.5 to 3 decibels of loss depending on how wide of a bandwidth of the input signal. As such, noise filter 300 may be beneficial when a significant part of the loss is in the low band frequency of the input signal. The noise filter 300 may be used to better shape the signal in the low band frequency to provide better SNR while at the same time allowing the lower loss in the high band of the system to be captured with better resolution. Further, another advantage of the noise filter 300 is the variable attenuator 108 or 202 and/or the variable delay line 110 or 210 only operate over half the bandwidth of a system. For example, for a 50GHz bandwidth system, the variable components only have to operate over 25Ghz bandwidth.

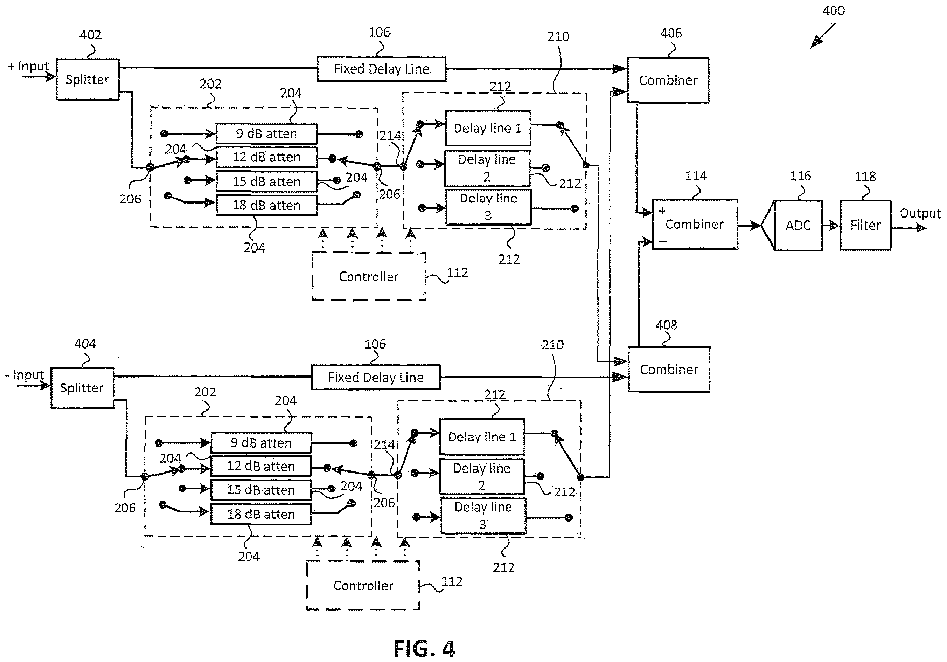

Fig. 4 illustrates another example noise filter 400 according to some embodiments of the disclosure. The noise filter 400 may be used when a differential signal pair is received from a DUT. A splitter 402, similar to splitter 102, receives and splits the positive signal of the differential pair into a signal on a first positive signal path and a signal on a second positive signal path, while a splitter 404, similar also to splitter 102, receives and splits the negative signal of the differential pair into a signal on a first negative signal path and a signal on a second negative signal path.

Both the first positive and the first negative signal paths include a fixed delay 106, as illustrated in Fig. 4. The second positive and negative signal paths each include a variable attenuator 108 or 202 and/or a variable delay line 110 or 210. The embodiment of Fig. 4 illustrates the use of a variable attenuator 202 and a variable delay line 210, as discussed in detail above with respect to Fig. 2. However, as will be understood by one skilled in the art, any combination of variable attenuators 108 or 202 and variable delay lines 110 or 210 may be used, as well as with one of the components being fixed.

A combiner 406 receives the signal from the first positive signal path and the signal from the second negative signal path and combines the signals into a first combined signal. A second combiner 408 receives the signal from the second positive signal path and the first negative signal path and combines the signals into a second combined signal. In such an embodiment, since the positive and negative signals are being combined, the combiners 406 and 408 may be, for example, power combiners. The first and second combined signals are then received at a combiner 114, similar to that discussed above with respect to Fig 1. The combiner 114 converts first and second combined signals into a single differential signal output which is received by ADC 116. That is, the noise filter 400 takes advantage of the differential signal pair to cross-couple the positive and negative signals to remove any attenuation from the test and measurement instrument channel.

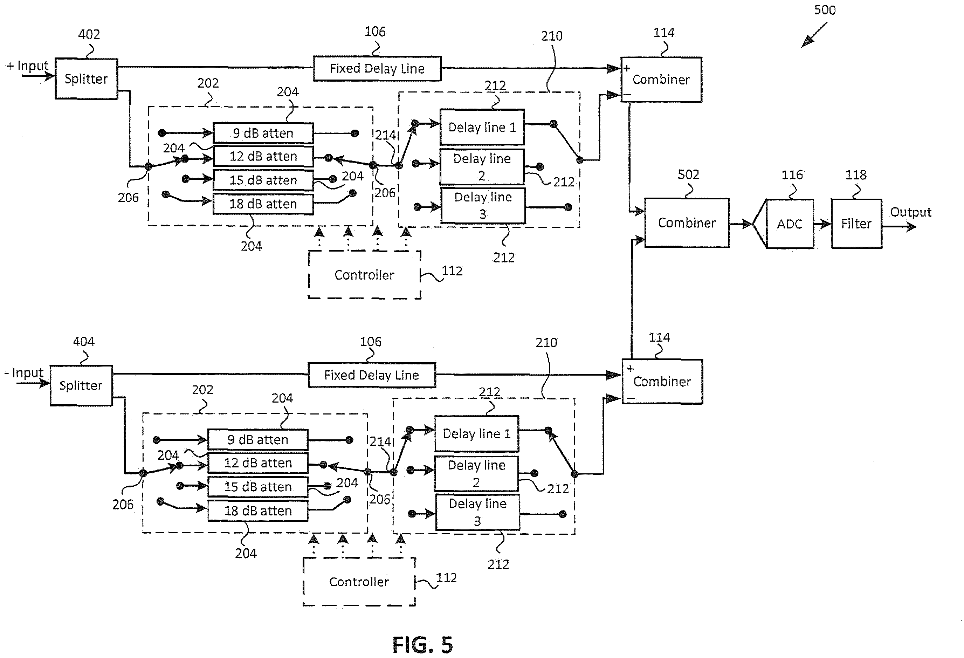

Fig. 5 illustrates a block diagram of another example noise filter 500 according to some embodiments of the disclosure. The noise filter 500 is similar to noise filter 400, except that there is no cross-coupling of the positive and negative signals of the differential signal pair, as shown in Fig. 4. As such, like components in Figs. 4 and 5 are not further described with respect to Fig. 5. Rather than having two simple combiners 406 and 408 combined by cross-coupling the positive and negative signals, two combiners 114, either baluns or differential amplifiers, for example, as discussed above, may be provided to couple each of the respective split positive signals and the respective split negative signals. The combined positive signal and the combined negative signal may then be further combined through combiner 502.

Further, similar to Fig. 4, any combination of variable attenuators 108 or 202 and variable delay lines 110 or 210 may be used, as well as with one of the components being fixed.

Alternative to the noise filter 500, a noise filter may be provided, similar to that shown in Fig. 5, but rather than combining the positive and negative branches into a single differential signal, as shown in Fig. 5, positive and negative signals paths may be processed separately through respective ADCs 116 and filters 118 and sent to the test and measurement instrument for further processing or stored in a memory as a differential signal pair, and not a combined differential signal.

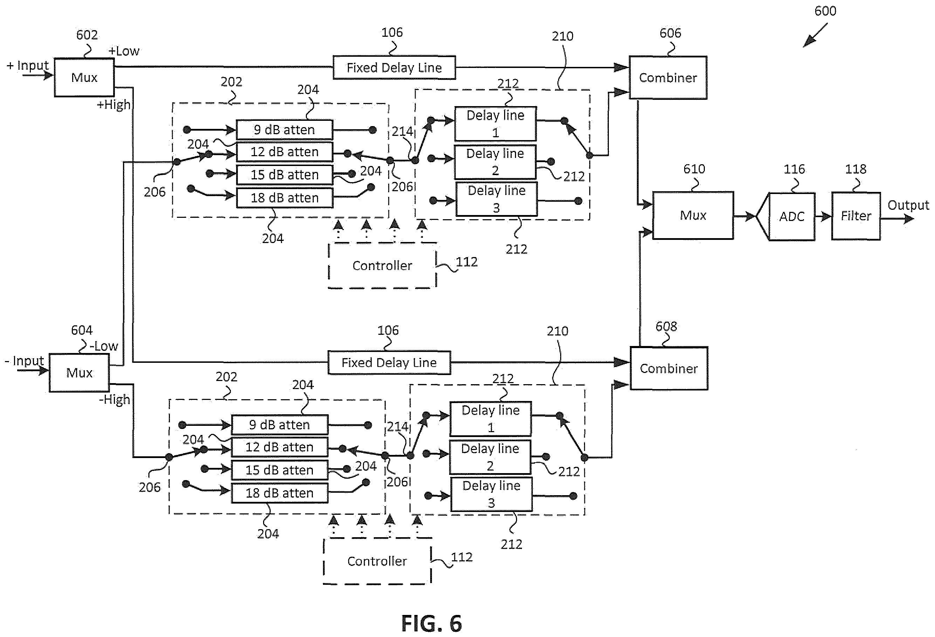

Fig. 6 illustrates a block diagram of another example noise filter 600 for a differential signal according to some embodiments of the disclosure. In noise filter 600, multiplexers 602 and 604 may be used to split the positive signal and the negative signal of a differential pair input signal into respective low band frequency and high band frequency signals. Both the positive low frequency band and positive high frequency band are delayed through fixed delay lines 106. The negative low frequency band and the negative high frequency band are received at paths that include a variable attenuator 108 or 202 and/or a variable delay line 110 or 210. The embodiment of Fig. 6 illustrates the use of a variable attenuator 202 and a variable delay line 210, as discussed in detail above with respect to Fig. 2. However, as will be understood by one skilled in the art, any combination of variable attenuators 108 or 202 and variable delay lines 110 or 210 may be used, as well as with one of the components being fixed.

The signals on the positive and negative low frequency paths may be combined at combiner 606 and the positive and negative high frequency paths may be combined at combiner 608 to output a combined low frequency band signal and a combined high frequency band signal. These signals may then be combined through another multiplexer 610 into a full frequency band combined signal.

It will be appreciated that the multiplexer configuration could be implemented into the two channel configurations of Figs. 1-3.

The above disclosed embodiments of the disclosure provide ways to adjust a frequency response of a noise filter over a high frequency bandwidth, such as frequency band widths at 70 GHz or greater, by having either a variable attenuator and/or a variable delay line in a signal path which may then be subtracted from a reference signal to remove noise added by a test and measurement instrument channel. Embodiments of the disclosure allow for a variable noise filter that can be programmed or set up for a variety of different test situations, rather than having to switch in a new noise filter for each test situation. Further, embodiments of the disclosure allow for adjusting the settings of a noise filter to test to a specific standard.

Aspects of the disclosure may operate on particularly created hardware, firmware, digital signal processors, or on a specially programmed computer including a processor operating according to programmed instructions. The terms controller or processor as used herein are intended to include microprocessors, microcomputers, Application Specific Integrated Circuits (ASICs), and dedicated hardware controllers. One or more aspects of the disclosure may be embodied in computer-usable data and computer-executable instructions, such as in one or more program modules, executed by one or more computers (including monitoring modules), or other devices. Generally, program modules include routines, programs, objects, components, data structures, etc. that perform particular tasks or implement particular abstract data types when executed by a processor in a computer or other device. The computer executable instructions may be stored on a computer readable storage medium such as a hard disk, optical disk, removable storage media, solid state memory, Random Access Memory (RAM), etc. As will be appreciated by one of skill in the art, the functionality of the program modules may be combined or distributed as desired in various aspects. In addition, the functionality may be embodied in whole or in part in firmware or hardware equivalents such as integrated circuits, FPGA, and the like. Particular data structures may be used to more effectively implement one or more aspects of the disclosure, and such data structures are contemplated within the scope of computer executable instructions and computer-usable data described herein.

The disclosed aspects may be implemented, in some cases, in hardware, firmware, software, or any combination thereof. The disclosed aspects may also be implemented as instructions carried by or stored on one or more or computer-readable storage media, which may be read and executed by one or more processors. Such instructions may be referred to as a computer program product. Computer-readable media, as discussed herein, means any media that can be accessed by a computing device. By way of example, and not limitation, computer-readable media may comprise computer storage media and communication media.

Computer storage media means any medium that can be used to store computer-readable information. By way of example, and not limitation, computer storage media may include RAM, ROM, Electrically Erasable Programmable Read-Only Memory (EEPROM), flash memory or other memory technology, Compact Disc Read Only Memory (CD-ROM), Digital Video Disc (DVD), or other optical disk storage, magnetic cassettes, magnetic tape, magnetic disk storage or other magnetic storage devices, and any other volatile or nonvolatile, removable or non-removable media implemented in any technology. Computer storage media excludes signals per se and transitory forms of signal transmission.

Communication media means any media that can be used for the communication of computer-readable information. By way of example, and not limitation, communication media may include coaxial cables, fiber-optic cables, air, or any other media suitable for the communication of electrical, optical, Radio Frequency (RF), infrared, acoustic or other types of signals.

Embodiments of the disclosed technology are generally directed to a multi-band variable filter, such as a variable passive CTLE circuit, and applications thereof. As used herein, a multi-band variable filter is a filter capable of applying different levels of attenuation to different frequency bands of a signal. For ease of reference, such a filter is referred to simply as a CTLE throughout this disclosure. The disclosed embodiments can exhibit various advantages, including, but not limited to, having a very wide bandwidth, and may include readily available components. In some embodiments it may be implemented into an RF module format. One aspect of this invention according to embodiments is to use a passive balun as a combiner to obtain a negative branch summation, which is part of setting up the desired frequency response shape to build a CTLE. One application is to use this CTLE in a test instrument to reduce noise added by the test instrument. Another application is to use the disclosed CTLE with Digital Signal Processor (DSP) equalization to implement a variable CTLE for a test setup.

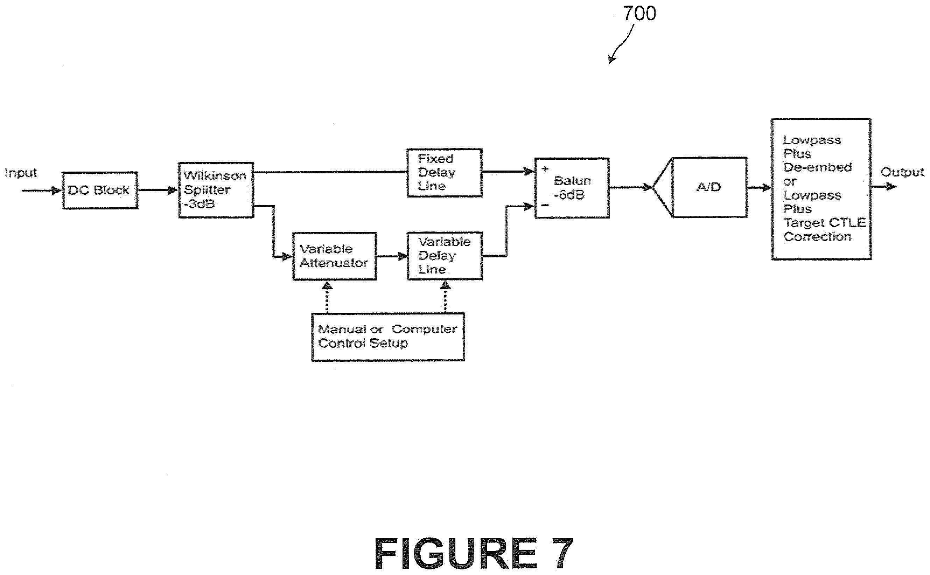

FIGURE 7 illustrates an example of a passive variable CTLE circuit 700 in accordance with certain embodiments of the disclosed technology. Certain embodiments may include a continuously or step variable CTLE passive circuit. In some embodiments the CTLE includes a splitter, attenuator, delay lines, and a balun combiner. For the version of this circuit that uses stepped control to vary the response, switches are used, as described below.

In more detail, the input signal of FIGURE 7 passes through a DC block and then into a splitter. A wideband Wilkinson splitter is preferred because it only has -3dB of signal loss. It is not necessary that the splitter operates to DC because most serial data standards do not either. Splitters other than Wilkinson splitters may also be used. For example, a three-resistor power splitter may be used, which has an approximate -6dB loss. Other splitters may also be used.

The splitter generates two outputs that are both passed to a balun through different signal paths. One path includes a fixed delay line while the other path may be one of a different length, or even one having a variable delay. The variable delay path leads to the inverting input of the balun. The fixed delay line leads to the non-inverting input of the balun. Adjusting the delay of the variable length path moves a pole location of the filter in frequency. It does this without changing the range of magnitude between high and low frequencies.

An attenuator may be incorporated into the variable delay path out of the splitter, i.e., the branch path that provides an input to the inverting side of the balun. This attenuator may be implemented with a variable attenuator or with fixed attenuators and switches to select which one is in use. The attenuator controls the difference in magnitude in dB between the low frequencies and the high frequencies. Adjusting the attenuator does not move the pole location of the filter.

The attenuator and the delay line may be fixed or variable or any combination. Adjusting the delay only shifts the peak frequency of the frequency response and changes the slope of it. Thus, delay may be changed to accommodate different data rate signals. The attenuator only changes the height of the frequency response peak without moving it in frequency. Thus, it may be adjusted to accommodate different DUT channel loss for given data rate.

Some embodiments of the invention use the balun as a means of combining the two branches and obtaining the negation of one of the branches. Using a balun in this way obtains the desired shape of the CTLE frequency response. For example, just using another Wilkinson combiner would not produce the correct frequency response shape. In other embodiments the balun could be replaced by an active differential amplifier. This provides an advantage of being able operate all the way to DC. It also provides gain. The disadvantage is that it would also introduce more noise.

After exiting the balun, the signal is digitized by an Analog-to-Digital (A/D) converter. Once in digital form, a digital signal processor (DSP) may be used whenever the test instrument channel is required to have a frequency response with a specific industry standard CTLE shape response. The analog variable CTLE hardware preferably would be set to be as close to the desired response and then this DSP filter would reshape it to be the exact desired response.

For systems where the CTLE is used for noise reduction, a DSP de-embed filter can reshape the frequency response of the test instrument channel back to flat. In so doing the noise introduced by the test instrument will be reduced without reducing the DUT noise.

In other embodiments, the DSP provides low pass filtering to limit the bandwidth to only include the first slope and peak of the CTLE frequency response. For example, if the CTLE response is sinusoidal in shape, the DSP may pass only the first slope as the output.

The final output may be saved in memory or streamed to real time processing systems.

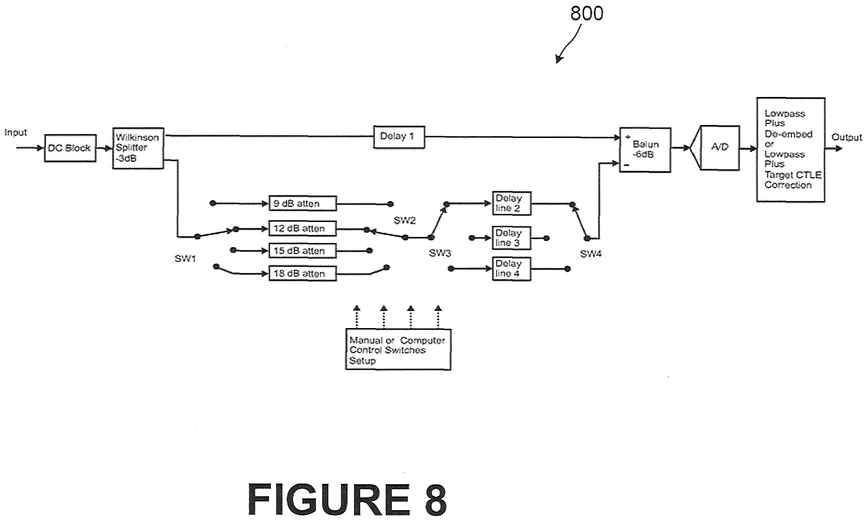

FIGURE 8 illustrates an implementation of the variable CTLE circuit 800 that allows a user to define the CTLE response using stepped control. In particular, manual or programmed switches are used to control the amount of attenuation and the amount of delay. In the embodiment illustrated in FIGURE 8, switches provide 12 different CTLE frequency responses by providing four different attenuation settings and three different pole location settings. One implementation uses two SP4T switches (SW1, SW2) to select any of four different attenuators, and uses two SP3T switches (SW3, SW4) to select one of three different delays. Thus, the embodiment illustrated in FIGURE 8 allows the user to generate 12 different CTLE frequency response settings.

The attenuation and the delay may be controlled either by manual operation or thru a computer interface.

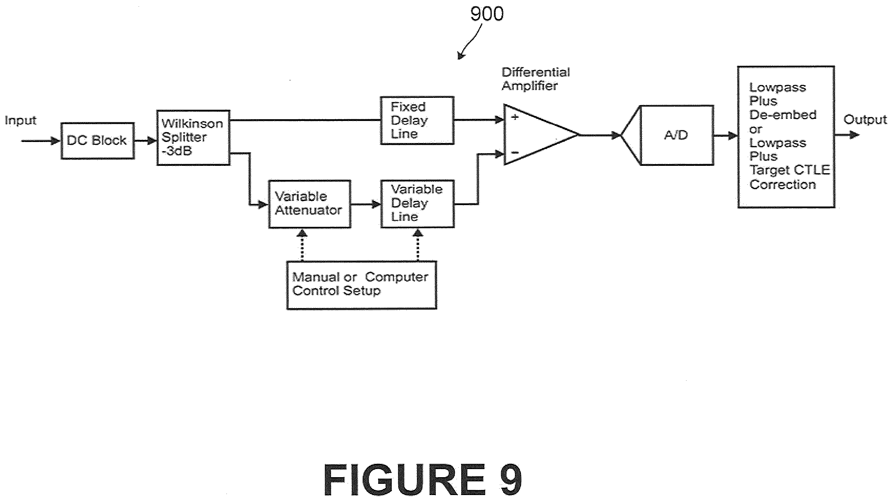

FIGURE 9 illustrates an optional configuration of a CTLE circuit 900 where the balun (illustrated in FIGURE 7) is replaced by an active differential amplifier to obtain the subtraction of the delayed and attenuated branch. The amplifier in the circuit 900 has a disadvantage of adding additional noise to the test instrument channel. The other disadvantage is decreased bandwidth. It would not be feasible to use existing amplifiers in a channel on a 70GHz oscilloscope. Baluns such as those illustrated in FIGURE 7, however, may operate up to 67GHz, and therefore may be incorporated within such a high speed oscilloscope. So, while the embodiment illustrated in FIGURE 9 may not be optional for all cases, it is functional and has purpose for some implementations.

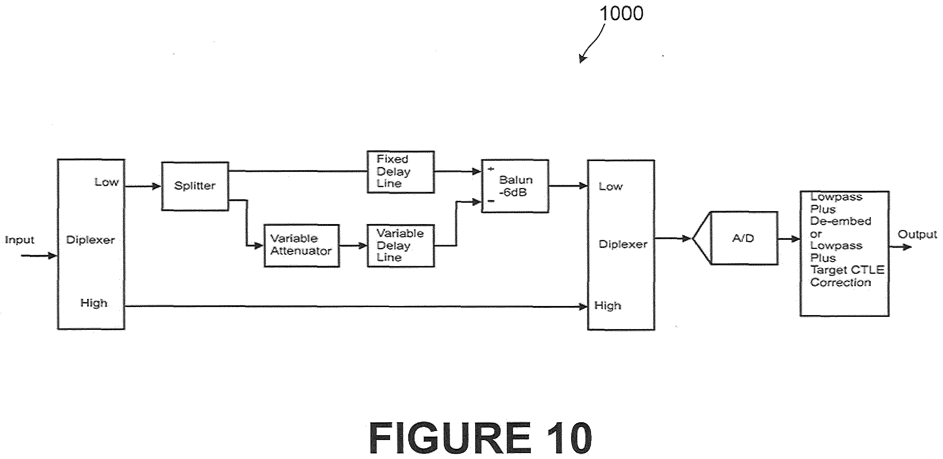

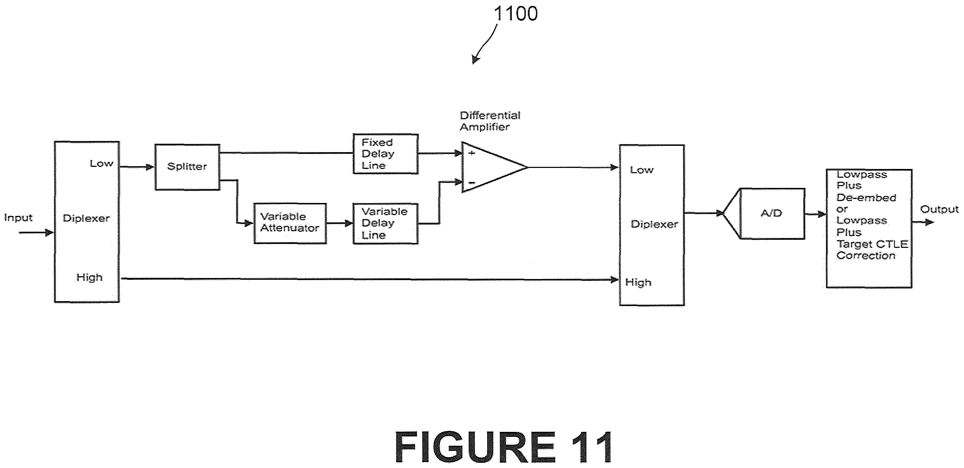

FIGURE 10 and FIGURE 11 illustrate embodiments of the invention 1000, 1100, that use diplexers to provide combining and lower loss configurations. FIGURE 10 illustrates a pair of diplexers used in conjunction with a balun, while FIGURE 11 illustrates a pair of diplexers used in conjunction with an active differential amplifier.

Diplexers typically exhibit much lower loss compared to signal splitters. In the low band, a diplexer may lose only a few tenths of a dB and in the high band the losses may be 1.5 to 3 dB depending on the desired bandwidth. Narrower bandwidths will have lower losses. Another advantage of using diplexers is that, when de-embedding a DUT and when the DUT being de-embedded has a significant part of the loss in the low band of the diplexer, the low band may be shaped better to provide better overall SNR. At the same time, lower losses in the high band of such a system mean the signal may be captured with better resolution. Yet another advantage to such a system using diplexers is that the variable delay and the variable attenuator need only operate over half the bandwidth of the system. Thus, for a 50GHz bandwidth system, those variable parts only have to operate over 25GHz bandwidth. That is especially important for reducing the cost of the balun which also only operates over 25GHz of bandwidth.

Other components of the system may also benefit from needing to perform only over lower bandwidth requirements, such as the switches used to control the variable attenuator and variable delay, such as described with reference to FIGURE 8.

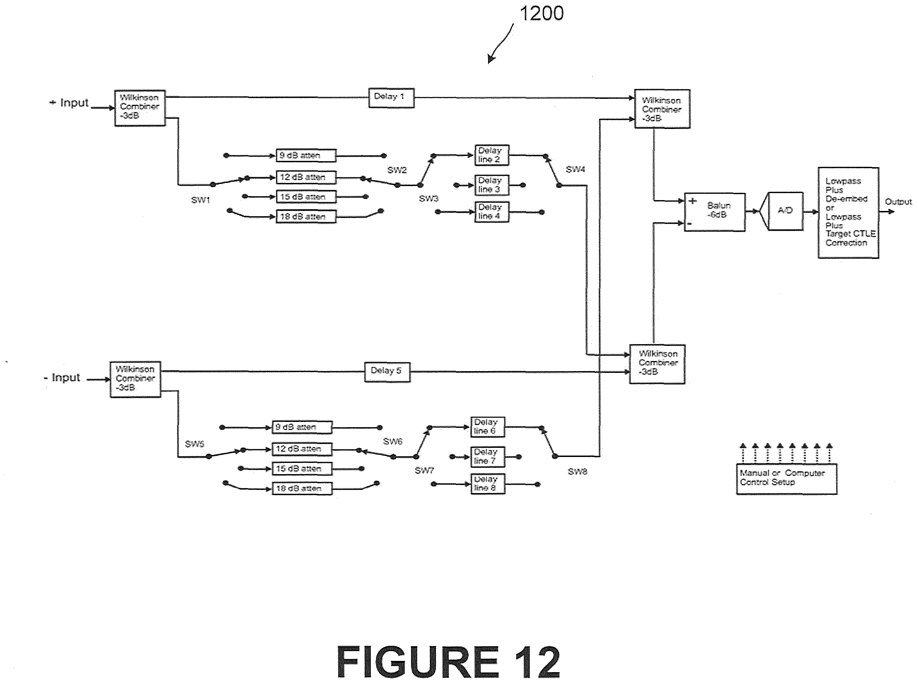

FIGURE 12 illustrates an example of a CTLE circuit 1200 that uses two, two-branch implementations described above with a modification that reduces the number of baluns needed from three to one. This supports a differential input into a single A/D converter. Such a system provides both a positive and a negative signal and thus, there is no need to have a balun to obtain a negative term for the CTLE filter as above with reference to FIGURES 7, 8, and 10. A simpler, less expensive combiner may be used in place of the balun. Thus, as shown in FIGURE 12, the positive input portion of a split signal passes through an attenuator and specific delay line and is summed in a power combiner along with the split negative input signal. This provides the desired CTLE response for the negative side of the differential signal. Likewise, a split negative side output goes through an attenuator selected by SW5 before going through a specific delay and is summed with the positive input. This results in the desired CTLE response for the positive side of the differential signal. Next these positive and the negative portions are fed into a balun to convert to the single differential signal output for a single A/D converter.

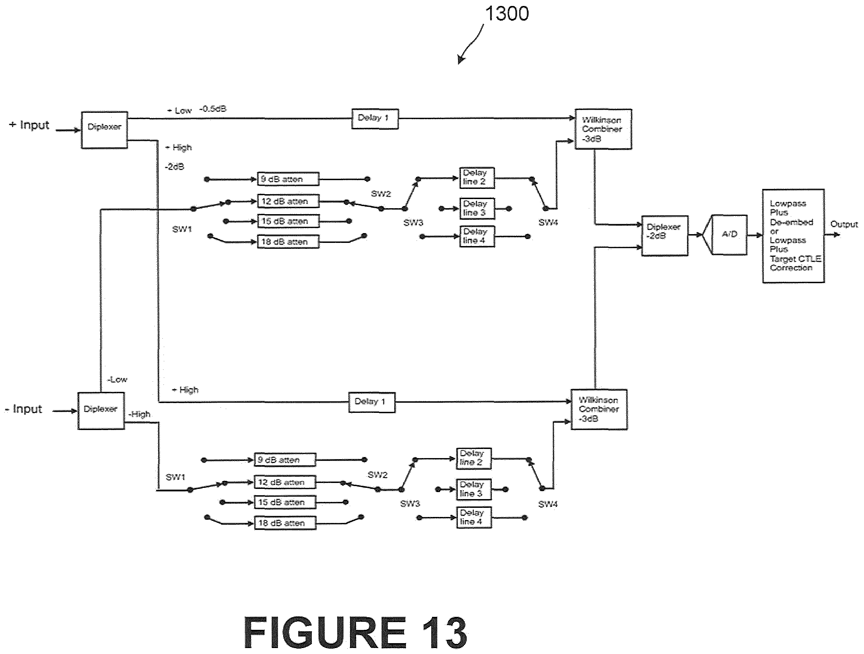

FIGURE 13 illustrates an example of a CTLE circuit 1300 in which each portion of a differential input signal uses an input diplexer. After the differential signals are combined, another diplexer combines the split bands back into a full band signal. This circuit 1300 has the advantage of not requiring a balun, which in some implementations may cause a rather large, 6dB loss. Instead, the diplexers have very low loss of, for example 0.5 dB in the lowband and 1-2 dB in the high band, depending on how wide a bandwidth is in use.

The circuit 1300 illustrated in FIGURE 13 uses the positive input for the signal, and the negative input to create the filter coefficients. As a result, it loses approximately 3 dB. However, as compared to the example illustrated in FIGURE 12, this architecture eliminated a 6 dB loss by eliminating the balun and replacing with a diplexer with much lower loss. Therefore, it achieves a net gain of approximately 1 dB SNR. Using a differential input signal also gives up the ability to reject common mode noise on the differential input lines.

The circuit 1300 effectively implements two CTLE filters, one for the high band and one for the low band. The coefficient circuits including the attenuators, delay lines, and switches are obtained from the negative input line of the differential input for both the high band and the low band. An interesting aspect of the circuit 1300 is that it eliminates the need for a balun with an inverting input, or for an amplifier with an inverting input, as illustrated in other embodiments.

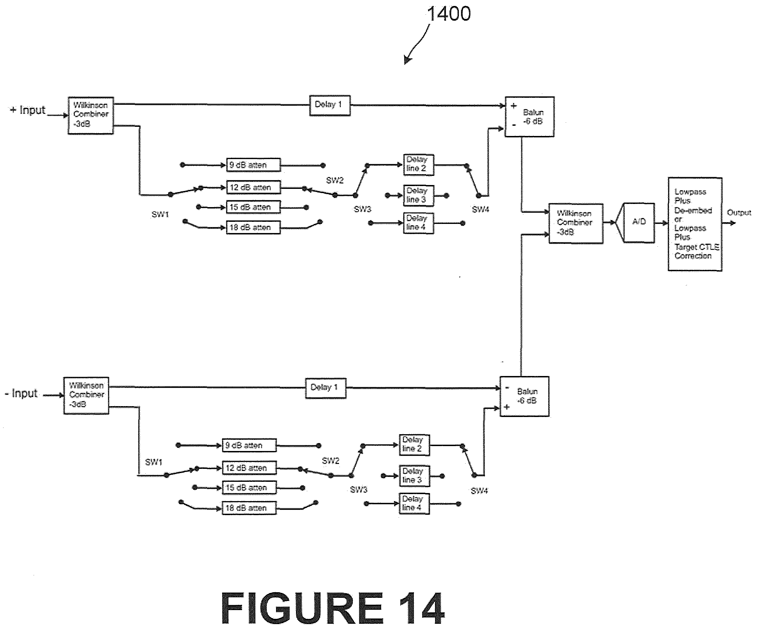

FIGURE 14 illustrates an example circuit 1400 that implements a differential input CTLE without cross coupling. Instead, the circuit 1400 uses two CTLE circuits, each using baluns for combining split signals. This circuit 1400 may also be implemented by using a differential amplifier in each leg of the differential path rather than baluns for combining.

In accordance with some embodiments discussed herein, a Mathcad simulation is shown below that illustrates various aspects of the disclosure.

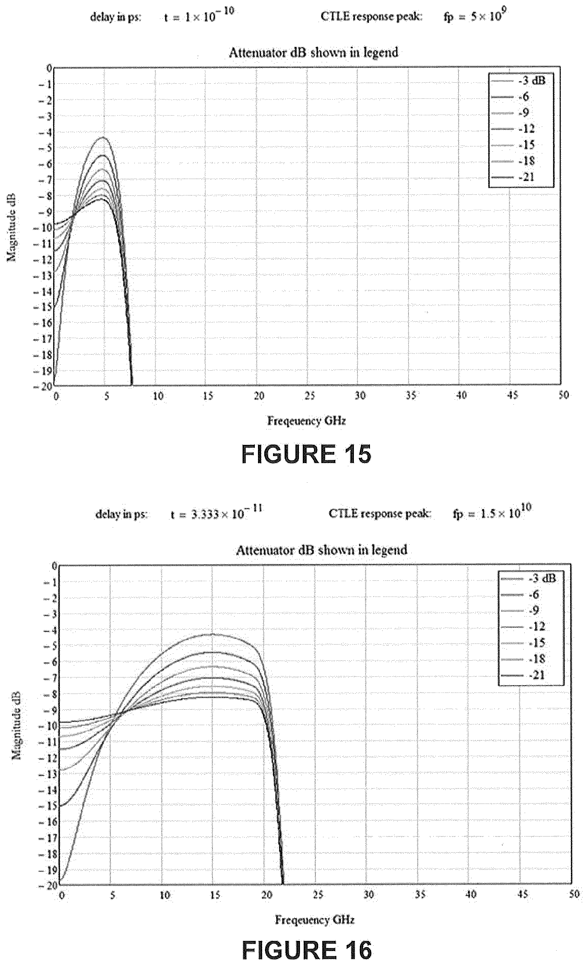

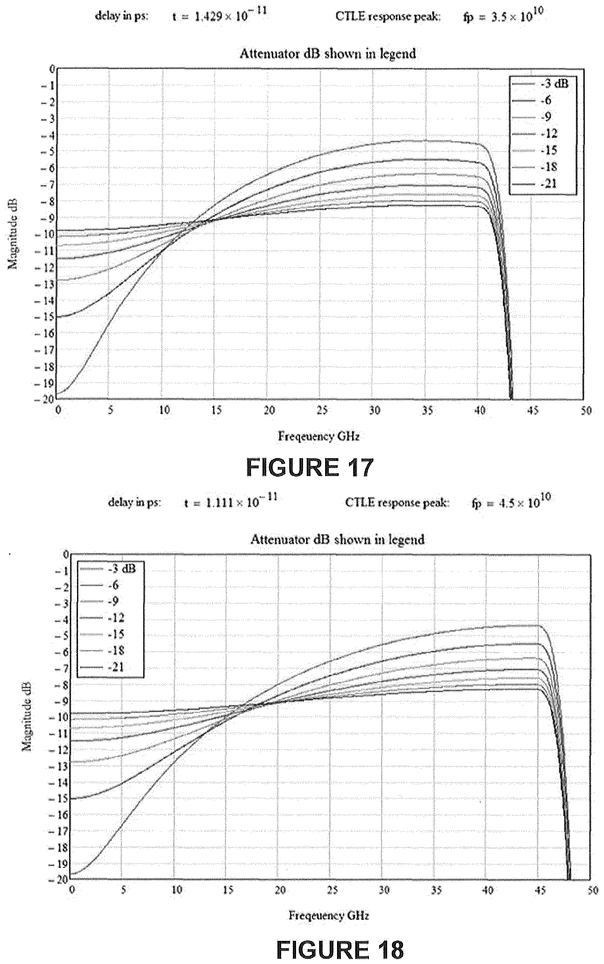

The non-limiting example Mathcad simulation shown includes an attenuation of the splitter at -3dB and the balun at -6 dB. The simulation shown includes multiple attenuators as labeled on the graphs of Figures 15 to 18. A separate graph is plotted for each fixed time delay value. The Mathcad simulation animation looks very similar to the real-time behavior observed on an actual device while adjusting the delay line.

An example frequency domain Mathcad model for the passive variable CTLE is shown below:

**Sample Rate**

$$fs := 100 \cdot 10^9$$

**The input signal**

$$Hin_n := 1$$

**Specify CTLE by giving the frequency, fp that defines the peak position of the frequency**

$$fp := 5 \cdot 10^9$$   Edit this value to change the frequency positon of the peak of the CTLE response.

$$t := \frac{1}{fp \cdot 2}$$   The delay difference between branches before the balun.

$$t = 1 \times 10^{-10}$$

**Create the DSP Lowpass filter**

$$M := 101$$

$$m := 0 .. M - 1$$

$$hbw := lowpass\left(\frac{fp \cdot 1.414}{fs}, M, 6\right)$$   The 1.414 value is to allow the response to go to its maximum possible peak value.

$$hh_n := 0$$

$$hh_{floor\left(\frac{N}{2}\right)+m} := hbw_m$$   +

$$Hfp := CFFT(hh)$$

$$Mhfp_n := 20 \cdot log\left(\left|Hfp_n\right|\right)$$

$$offset := Mhfp_0$$

$$Mhfp := Mhfp - offset$$

**Create the delay function Hd**

$$Hd(n,t) := \cos\left(-2 \cdot \pi \cdot t \cdot \frac{n}{N} \cdot fs\right) + j \cdot \sin\left(-2 \cdot \pi \cdot t \cdot \frac{n}{N} \cdot fs\right)$$

delay in terms of a specified time delay t

$$Hf(n,fp) := \cos\left(-\pi \cdot \frac{n}{N} \cdot \frac{fs}{fp}\right) + j \cdot \sin\left(-\pi \cdot \frac{n}{N} \cdot \frac{fs}{fp}\right)$$

delay in terms of the frequency, fp, where peak occurs

The power splitter loses 3 dB and the balun loses 6 dB. Therefore, make a final scale factor for the signal.

$$scale := 10^{\frac{-3-6}{20}}$$
+

$$scale = 0.355$$
This is the total loss thru the circuit.

$$Hout(Hin,fp,attScale,scale,N) := \begin{array}{|l} \text{for } n \in 0..N-1 \\ \quad y_n \leftarrow Hin_n \cdot (1 - attScale \cdot Hf(n,fp)) \cdot scale \\ \text{return } y \end{array}$$

Hout is a function that computes the frequency response given the fp peak response frequency, and the attenuation value in attScale. The value of scale is the loss of the Wilkinson divider and the loss of the balun. The Hf() function creates the desired delay. The equations shown below compute a frequency response for each combination of attenuation and delay requested.

**Compute a response curve for each of the different attenuator settings in steps of 3dB**

$$Y1 := Hout\left(Hin,fp,10^{\frac{-3}{20}},scale,N\right) \qquad Y2 := Hout\left(Hin,fp,10^{\frac{-6}{20}},scale,N\right) \qquad Y3 := Hout\left(Hin,fp,10^{\frac{-9}{20}},scale,N\right)$$

$$Y4 := Hout\left(Hin,fp,10^{\frac{-12}{20}},scale,N\right) \qquad Y5 := Hout\left(Hin,fp,10^{\frac{-15}{20}},scale,N\right) \qquad Y6 := Hout\left(Hin,fp,10^{\frac{-18}{20}},scale,N\right)$$

$$Y7 := Hout\left(Hin,fp,10^{\frac{-21}{20}},scale,N\right)$$

$$My1_n := 20 \cdot \log\left(\left|Y1_n\right|\right) + Mhfp_n \qquad My2_n := 20 \cdot \log\left(\left|Y2_n\right|\right) + Mhfp_n \qquad My3_n := 20 \cdot \log\left(\left|Y3_n\right|\right) + Mhfp_n$$

$$My4_n := 20 \cdot \log\left(\left|Y4_n\right|\right) + Mhfp_n \qquad My5_n := 20 \cdot \log\left(\left|Y5_n\right|\right) + Mhfp_n \qquad My6_n := 20 \cdot \log\left(\left|Y6_n\right|\right) + Mhfp_n$$

$$My7_n := 20 \cdot \log\left(\left|Y7_n\right|\right) + Mhfp_n$$

For this example simulation, the lowpass was added in units of dB to the CTLE response.

Equation Summary:

The basic frequency domain equation that implements the single pole CTLE filter operation is defined by the following equation. This equation is represented in discrete sampled form.

$$Y(n) = X(n) \cdot (1 - a \cdot e^{\frac{-j \cdot 2 \cdot \pi \cdot fs \cdot n}{N \cdot fp}})$$

Where:

Y is the frequency domain representation of the output signal of the CTLE filter.
X is the frequency domain input signal
a is the scale factor of gain loss due to the attenuator.
fs is the sample rate of the frequency domain represented signals.
fp is the frequency location of the CTLE peak of the frequency response.
n is the frequency index and N is the number of frequency points in the spectrum.
t in the alternative equation below is the delay in seconds of the delay line in the coefficient branch. This is the delay difference between the straight thru branch and attenuated delayed branch.

$$Y(n) = X(n) \cdot (1 - a \cdot e^{\frac{-j \cdot 2 \cdot \pi \cdot t \cdot n}{N}})$$

where: t = 1 / (2 fp)

The previously described versions of the disclosed subject matter have many advantages that were either described or would be apparent to a person of ordinary skill. Even so, these advantages or features are not required in all versions of the disclosed apparatus, systems, or methods.

Additionally, this written description makes reference to particular features. It is to be understood that the disclosure in this specification includes all possible combinations of those particular features. Where a particular feature is disclosed in the context of a particular aspect or example, that feature can also be used, to the extent possible, in the context of other aspects and examples.

Also, when reference is made in this application to a method having two or more defined steps or operations, the defined steps or operations can be carried out in any order or simultaneously, unless the context excludes those possibilities.

Although specific examples of the invention have been illustrated and described for purposes of illustration, it will be understood that various modifications may be made without departing from the scope of the invention. Accordingly, the invention should not be limited except as by the appended claims.

**Claims**

1. A noise filter (100) for reducing noise added by a particular channel of a test and measurement instrument, the noise filter comprising:

   a splitter (104) configured to receive a signal and split the signal into at least a first split signal and a second split signal;
   a first path configured to receive the first split signal, the first path including:

   a variable attenuator (108), and
   a variable delay line (110);

   a second path configured to receive the second split signal;
   a combiner (114) configured to combine a signal from the first path and a signal from the second path into a combined signal;
   an analog-to-digital (116) converter configured to receive the combined signal and output a digital signal representing the combined signal; and
   a filter (118) configured to receive the digital signal and output a filtered digital signal;
   wherein at least one of the variable attenuator and the variable delay line are adjusted based on the particular channel of the test and measurement instrument.

2. The noise filter of claim 1, wherein the second path includes a fixed delay line; and/or wherein at least one of the variable attenuator and the variable delay line are adjusted by a controller.

3. The noise filter of claim 1 or 2, wherein the variable attenuator includes:

a plurality of attenuators, each attenuator having a different attenuation amount; and
a plurality of switches,
wherein the variable attenuator is adjusted by switching one of the plurality of attenuators into the first path; and/or

wherein the variable delay line includes:

a plurality of delay lines, each delay line having a different delay amount; and
a plurality of switches,
wherein the variable delay line is adjusted by switching one of the plurality of delay lines into the first path.

4. The noise filter of any of claims 1 to 3, wherein the combiner is a balun having an inverted input and a non-inverted input, and/or
wherein the combiner is a differential amplifier.

5. The noise filter of any of claims 1 to 4, further comprising a multiplexer configured to receive an input signal and separate the input signal into a high frequency band signal and a low frequency band signal, wherein the signal received by the splitter is the low frequency band signal; and optionally
wherein the multiplexer is a first multiplexer and the combined signal is a first combined signal, and the noise filter further comprises a second multiplexer configured to receive the first combined signal and the high frequency band signal and output a second combined signal.

6. The noise filter of any of claims 1 to 5, wherein:

the filter (118) includes a reshaping filter configured to receive the digital signal and output a filtered digital signal that matches a specific continuous time linear equalizer shape response; and/or
the filter (118) includes a lowpass filter configured to limit the bandwidth of the digital signal to only include the first slope and peak of the digital signal; and/or
the filter (118) includes a de-embed filter configured to reshape a frequency response of the particular channel of the test and measurement instrument to a flat response.

7. The noise filter of any of claims 1 to 6, wherein the signal is a positive signal of a differential signal pair, the splitter is a first splitter, the combiner is a first combiner, and the combined signal is a first combined signal, the noise filter further comprising:

a second splitter configured to receive a negative signal of the differential signal pair and split the negative signal into at least a third split signal and a fourth split signal;
a third path configured to receive the third split signal, the third path including:

a second variable attenuator, and
a second variable delay line;

a fourth path configured to receive the fourth split signal;
a second combiner configured to combine a signal from the second path and a signal from the third path into a second combined signal; and
a third combiner configured to combine the first combined signal and the second combined signal into a third combined signal.

8. The noise filter of claim 7, wherein the second path and the fourth path includes a fixed delay line; and/or
wherein at least one of the first variable attenuator, the first variable delay line, the second variable attenuator and the second variable delay line are adjusted by a controller.

9. The noise filter of claim 7 or 8, wherein at least one of the first variable attenuator and the second variable attenuator includes:

a plurality of attenuators, each attenuator having a different attenuation amount; and
a plurality of switches,
wherein the at least one of the first variable attenuator and the second variable attenuator is adjusted by switching one of the plurality of attenuators into the first path; and/or

wherein at least one of the first variable delay line and the second variable delay includes:

a plurality of delay lines, each delay line having a different delay amount; and
a plurality of switches,
wherein at least one of the first variable delay line and the second variable delay is adjusted by switching one of the plurality of delay lines into the first path.

10. The noise filter of any of claims 7 to 9, wherein the third combiner is a balun having an inverted input and a non-inverted input; and/or
wherein at least one of the first combiner, the second combiner, and the third combiner is a multiplexer.

11. The noise filter of any of claims 7 to 10, further comprising:

an analog-to-digital converter configured to receive the third combined signal and output a digital signal representing the third combined signal; and
a filter configured to receive the digital signal and output a filtered digital signal; and/or
wherein each of the first and second split signals include substantially the entire bandwidth of the positive signal, and each of the third and fourth signals include substantially the entire bandwidth of the negative signal.

12. The noise filter of any of claims 7 to 11,

wherein the first splitter is a first multiplexer and the second splitter is a second multiplexer, and
wherein the first split signal includes a first bandwidth of the positive signal and the second split signal includes a second bandwidth of the positive signal, the first bandwidth and the second bandwidth being different from one another, and
wherein the third split signal includes a third bandwidth of the negative signal and the fourth split signal includes a fourth bandwidth of the negative signal, the third bandwidth and the fourth bandwidth being different from one another.

13. A method for reducing noise added by a particular channel of a test and measurement instrument, the method comprising:

splitting a signal into at least a first split signal and a second split signal;
setting an attenuation amount for a variable attenuator (108);
setting a delay amount for a variable delay line (110);
attenuating by the attenuation amount the first split signal through the variable attenuator (108);
delaying by the delay amount the attenuated first split signal through the variable delay line (110);
combining the delayed and attenuated first split signal and the second split signal into a combined signal;
converting the combined signal into a digital signal representing the combined signal; and
filtering the digital signal to output a filtered digital signal;
wherein at least one of the attenuation amount or the delay amount are set based on the particular channel of the test and measurement instrument.

14. The method of claim 13, further comprising delaying the second split signal through a fixed delay line prior to combining the second split signal and the delayed and attenuated first split signal; and/or

wherein setting the attenuation amount for the variable attenuator includes switching in one of a plurality of different attenuators; and/or
wherein setting the delay amount for the variable delay line includes switching in one of a plurality of different delay lines.

15. The method of claim 13 or 14, wherein the signal is a first signal, the method further comprising splitting an input signal into a high frequency band signal and a low frequency band signal, wherein the first signal is the low frequency band signal, and wherein the combined signal is a first combined signal, and the method further comprises combining the first combined signal and the high frequency band signal into a second combined signal; and/or wherein filtering the digital signal comprises:

filtering the digital signal to match a specific continuous time linear equalizer shape response; and/or filtering the digital signal to limit the bandwidth to include only the first slope and peak of the digital signal; and/or filtering the digital signal to reshape the frequency response of the particular channel of the test and measurement instrument to a flat response.

**Patentansprüche**

1. Rauschfilter (100) zum Reduzieren von Rauschen, das durch einen bestimmten Kanal eines Test- und Messinstruments hinzugefügt wird, wobei der Rauschfilter Folgendes umfasst:

einen Teiler (104), der konfiguriert ist, um ein Signal zu empfangen und das Signal in zumindest ein erstes geteiltes Signal und ein zweites geteiltes Signal zu teilen;
einen ersten Pfad, der konfiguriert ist, um das erste geteilte Signal zu empfangen, wobei der erste Pfad Folgendes beinhaltet: einen variablen Dämpfer (108) und eine variable Verzögerungsleitung (110);
einen zweiten Pfad, der konfiguriert ist, um das zweite geteilte Signal zu empfangen;
einen Kombinierer (114), der konfiguriert ist, um ein Signal von dem ersten Pfad und ein Signal von dem zweiten Pfad zu einem kombinierten Signal zu kombinieren;
einen Analog-Digital-Wandler (116), der konfiguriert ist, um das kombinierte Signal zu empfangen und ein digitales Signal auszugeben, welches das kombinierte Signal darstellt; und
einen Filter (118), der konfiguriert ist, um das digitale Signal zu empfangen und ein gefiltertes digitales Signal auszugeben;
wobei zumindest eines von dem variablen Dämpfer und der variablen Verzögerungsleitung basierend auf dem bestimmten Kanal des Test- und Messinstruments eingestellt sind.

2. Rauschfilter nach Anspruch 1, wobei der zweite Pfad eine feste Verzögerungsleitung beinhaltet; und/oder wobei zumindest eines von dem variablen Dämpfer und der variablen Verzögerungsleitung durch eine Steuerung eingestellt sind.

3. Rauschfilter nach Anspruch 1 oder 2, wobei der variable Dämpfer Folgendes beinhaltet:

eine Vielzahl von Dämpfern, wobei jeder Dämpfer eine unterschiedliche Dämpfungsmenge aufweist; und eine Vielzahl von Schaltern,
wobei der variable Dämpfer eingestellt wird, indem einer aus der Vielzahl von Dämpfern in den ersten Pfad geschaltet wird; und/oder
wobei die variable Verzögerungsleitung Folgendes beinhaltet:

eine Vielzahl von Verzögerungsleitungen, wobei jede Verzögerungsleitung eine unterschiedliche Verzögerungsmenge aufweist; und eine Vielzahl von Schaltern,
wobei die variable Verzögerungsleitung eingestellt wird, indem eine aus der Vielzahl von Verzögerungsleitungen in den ersten Pfad geschaltet wird.

4. Rauschfilter nach einem der Ansprüche 1 bis 3, wobei der Kombinierer ein Balun ist, der einen invertierten Eingang und einen nicht invertierten Eingang aufweist, und/oder wobei der Kombinierer ein Differentialverstärker ist.

5. Rauschfilter nach einem der Ansprüche 1 bis 4, ferner umfassend einen Multiplexer, der konfiguriert ist, um ein Eingangssignal zu empfangen und das Eingangssignal in ein Hochfrequenzbandsignal und ein Niederfrequenzbandsignal zu trennen, wobei das Signal, das durch den Teiler empfangen wird, das Niederfrequenzbandsignal ist; und optional wobei der Multiplexer ein erster Multiplexer ist und das kombinierte Signal ein erstes kombiniertes Signal ist und der Rauschfilter ferner einen zweiten Multiplexer umfasst, der konfiguriert ist, um das erste kombinierte Signal und das Hochfrequenzbandsignal zu empfangen und ein zweites kombiniertes Signal auszugeben.

6. Rauschfilter nach einem der Ansprüche 1 bis 5, wobei:

der Filter (118) einen Umformungsfilter beinhaltet, der konfiguriert ist, um das digitale Signal zu empfangen und ein gefiltertes digitales Signal auszugeben, das einer spezifischen zeitkontinuierlichen linearen Equalizer-Formreaktion entspricht; und/oder
der Filter (118) einen Tiefpassfilter beinhaltet, der konfiguriert ist, um die Bandbreite des digitalen Signals zu begrenzen, um nur die erste Steigung und Spitze des digitalen Signals zu beinhalten; und/oder
der Filter (118) einen De-Embed-Filter beinhaltet, der konfiguriert ist, um eine Frequenzreaktion des bestimmten Kanals des Test- und Messinstruments in eine flache Reaktion umzuformen.

7. Rauschfilter nach einem der Ansprüche 1 bis 6, wobei das Signal ein positives Signal eines Differentialsignalpaares ist, der Teiler ein erster Teiler ist, der Kombinierer ein erster Kombinierer ist und das kombinierte Signal ein erstes kombiniertes Signal ist, wobei der Rauschfilter ferner Folgendes umfasst:

einen zweiten Teiler, der konfiguriert ist, um ein negatives Signal des Differentialsignalpaares zu empfangen und das negative Signal in zumindest ein drittes geteiltes Signal und ein viertes geteiltes Signal zu teilen;
einen dritten Pfad, der konfiguriert ist, um das dritte geteilte Signal zu empfangen, wobei der dritte Pfad Folgendes beinhaltet: einen zweiten variablen Dämpfer und eine zweite variable Verzögerungsleitung;
einen vierten Pfad, der konfiguriert ist, um das vierte geteilte Signal zu empfangen;
einen zweiten Kombinierer, der konfiguriert ist, um ein Signal von dem zweiten Pfad und ein Signal von dem dritten Pfad zu einem zweiten kombinierten Signal zu kombinieren; und
einen dritten Kombinierer, der konfiguriert ist, um das erste kombinierte Signal und das zweite kombinierte Signal zu einem dritten kombinierten Signal zu kombinieren.

8. Rauschfilter nach Anspruch 7, wobei der zweite Pfad und der vierte Pfad eine feste Verzögerungsleitung beinhalten; und/oder
wobei zumindest eines von dem ersten variablen Dämpfer, der ersten variablen Verzögerungsleitung, dem zweiten variablen Dämpfer und der zweiten variablen Verzögerungsleitung durch eine Steuerung eingestellt sind.

9. Rauschfilter nach Anspruch 7 oder 8, wobei zumindest einer von dem ersten variablen Dämpfer und dem zweiten variablen Dämpfer Folgendes beinhaltet:

eine Vielzahl von Dämpfern, wobei jeder Dämpfer eine unterschiedliche Dämpfungsmenge aufweist; und
eine Vielzahl von Schaltern,
wobei der zumindest einer von dem ersten variablen Dämpfer und dem zweiten variablen Dämpfer eingestellt wird, indem einer aus der Vielzahl von Dämpfern in den ersten Pfad geschaltet wird, und/oder
wobei zumindest eine von der ersten variablen Verzögerungsleitung und der zweiten variablen Verzögerung Folgendes beinhaltet:

eine Vielzahl von Verzögerungsleitungen, wobei jede Verzögerungsleitung eine unterschiedliche Verzögerungsmenge aufweist; und eine Vielzahl von Schaltern,
wobei zumindest eine von der ersten variablen Verzögerungsleitung und der zweiten variablen Verzögerung eingestellt wird, indem eine aus der Vielzahl von Verzögerungsleitungen in den ersten Pfad geschaltet wird.

10. Rauschfilter nach einem der Ansprüche 7 bis 9, wobei der dritte Kombinierer ein Balun ist, der einen invertierten Eingang und einen nicht invertierten Eingang aufweist; und/oder
wobei zumindest einer von dem ersten Kombinierer, dem zweiten Kombinierer und dem dritten Kombinierer ein Multiplexer ist.

11. Rauschfilter nach einem der Ansprüche 7 bis 10, ferner umfassend:

einen Analog-Digital-Wandler, der konfiguriert ist, um das dritte kombinierte Signal zu empfangen und ein digitales Signal auszugeben, welches das dritte kombinierte Signal darstellt; und
einen Filter, der konfiguriert ist, um das digitale Signal zu empfangen und ein gefiltertes digitales Signal auszugeben;
und/oder
wobei jedes von dem ersten und dem zweiten geteilten Signal im Wesentlichen die gesamte Bandbreite des positiven Signals beinhaltet und jedes von dem dritten und dem vierten Signal im Wesentlichen die gesamte Bandbreite des negativen Signals beinhaltet.

**12.** Rauschfilter nach einem der Ansprüche 7 bis 11,

wobei der erste Teiler ein erster Multiplexer ist und der zweite Teiler ein zweiter Multiplexer ist, und
wobei das erste geteilte Signal eine erste Bandbreite des positiven Signals beinhaltet und das zweite geteilte Signal eine zweite Bandbreite des positiven Signals beinhaltet, wobei die erste Bandbreite und die zweite Bandbreite unterschiedlich zueinander sind, und
wobei das dritte geteilte Signal eine dritte Bandbreite des negativen Signals beinhaltet und das vierte geteilte Signal eine vierte Bandbreite des negativen Signals beinhaltet, wobei die dritte Bandbreite und die vierte Bandbreite unterschiedlich zueinander sind.

**13.** Verfahren zum Reduzieren von Rauschen, das durch einen bestimmten Kanal eines Test- und Messinstruments hinzugefügt wird, wobei das Verfahren Folgendes umfasst:

Teilen eines Signals in zumindest ein erstes geteiltes Signal und ein zweites geteiltes Signal;
Festlegen einer Dämpfungsmenge für einen variablen Dämpfer (108);
Festlegen einer Verzögerungsmenge für eine variable Verzögerungsleitung (110);
Dämpfen des ersten geteilten Signals um die Dämpfungsmenge durch den variablen Dämpfer (108);
Verzögern des gedämpften ersten geteilten Signals um die Verzögerungsmenge durch die variable Verzögerungsleitung (110);
Kombinieren des verzögerten und gedämpften ersten geteilten Signals und des zweiten geteilten Signals zu einem kombinierten Signal;
Umwandeln des kombinierten Signals in ein digitales Signal, welches das kombinierte Signal darstellt; und
Filtern des digitalen Signals, um ein gefiltertes digitales Signal auszugeben;
wobei zumindest eine von der Dämpfungsmenge oder der Verzögerungsmenge basierend auf dem bestimmten Kanal des Test- und Messinstruments festgelegt werden.

**14.** Verfahren nach Anspruch 13, ferner umfassend das Verzögern des zweiten geteilten Signals durch eine feste Verzögerungsleitung vor dem Kombinieren des zweiten geteilten Signals und des verzögerten und gedämpften ersten geteilten Signals; und/oder

wobei das Festlegen der Dämpfungsmenge für den variablen Dämpfer das Schalten in einen aus einer Vielzahl von unterschiedlichen Dämpfern beinhaltet; und/oder
wobei das Festlegen der Verzögerungsmenge für die variable Verzögerungsleitung das Schalten in eine aus einer Vielzahl von unterschiedlichen Verzögerungsleitungen beinhaltet.

**15.** Verfahren nach Anspruch 13 oder 14, wobei das Signal ein erstes Signal ist, wobei das Verfahren ferner das Teilen eines Eingangssignals in ein Hochfrequenzbandsignal und ein Niederfrequenzbandsignal umfasst, wobei das erste Signal das Niederfrequenzbandsignal ist, und wobei das kombinierte Signal ein erstes kombiniertes Signal ist und das Verfahren ferner das Kombinieren des ersten kombinierten Signals und des Hochfrequenzbandsignals zu einem zweiten kombinierten Signal umfasst; und/oder
wobei das Filtern des digitalen Signals Folgendes umfasst:

Filtern des digitalen Signals, um einer spezifischen zeitkontinuierlichen linearen Equalizer-Formreaktion zu entsprechen; und/oder
Filtern des digitalen Signals, um die Bandbreite zu begrenzen, um nur die erste Steigung und Spitze des digitalen Signals zu beinhalten; und/oder
Filtern des digitalen Signals, um die Frequenzreaktion des bestimmten Kanals des Test- und Messinstruments in eine flache Frequenzreaktion umzuformen.

**Revendications**

**1.** Filtre de bruit (100) destiné à réduire le bruit ajouté par un canal particulier d'un instrument d'essai et de mesure, le filtre de bruit comprenant :

un diviseur (104) conçu pour recevoir un signal et diviser le signal en au moins un premier signal divisé et un deuxième signal divisé ;
un premier chemin conçu pour recevoir le premier signal divisé, le premier chemin comprenant : un atténuateur variable (108) et une ligne à retard variable (110) ;
un deuxième chemin conçu pour recevoir le deuxième signal divisé ;
un combineur (114) conçu pour combiner un signal provenant du premier chemin et un signal provenant du deuxième chemin en un signal combiné ;
un convertisseur analogique-numérique (116) conçu pour recevoir le signal combiné et délivrer en sortie un signal numérique représentant le signal combiné ; et
un filtre (118) conçu pour recevoir le signal numérique et délivrer en sortie un signal numérique filtré ;
au moins l'un de l'atténuateur variable et de la ligne à retard variable étant réglé sur la base du canal particulier de l'instrument d'essai et de mesure.

2. Filtre de bruit selon la revendication 1, ledit deuxième chemin comprenant une ligne à retard fixe ; et/ou au moins l'un de l'atténuateur variable et de la ligne à retard variable étant réglé par un dispositif de commande.

3. Filtre de bruit selon la revendication 1 ou 2, ledit atténuateur variable comprenant :

une pluralité d'atténuateurs, chaque atténuateur possédant une valeur d'atténuation différente ; et
une pluralité de commutateurs,
ledit atténuateur variable étant réglé en commutant l'un de la pluralité d'atténuateurs dans le premier chemin ; et/ou
ladite ligne à retard variable comprenant :

une pluralité de lignes à retard, chaque ligne à retard possédant une quantité de retard différente ; et une pluralité de commutateurs,
ladite ligne à retard variable étant réglée en commutant l'une de la pluralité de lignes à retard dans le premier chemin.

4. Filtre de bruit selon l'une quelconque des revendications 1 à 3, ledit combineur étant un balun possédant une entrée inversée et une entrée non inversée, et/ou
ledit combineur étant un amplificateur différentiel.

5. Filtre de bruit selon l'une quelconque des revendications 1 à 4, comprenant en outre un multiplexeur conçu pour recevoir un signal d'entrée et séparer le signal d'entrée en un signal de bande haute fréquence et un signal de bande basse fréquence, ledit signal reçu par le diviseur étant le signal de bande basse fréquence ; et éventuellement ledit multiplexeur étant un premier multiplexeur et ledit signal combiné étant un premier signal combiné, et ledit filtre de bruit comprenant en outre un second multiplexeur conçu pour recevoir le premier signal combiné et le signal de bande haute fréquence et délivrer en sortie un deuxième signal combiné.

6. Filtre de bruit selon l'une quelconque des revendications 1 à 5,

ledit filtre (118) comprenant un filtre de remise en forme conçu pour recevoir le signal numérique et délivrer en sortie un signal numérique filtré qui correspond à une réponse de forme d'égaliseur linéaire à temps continu spécifique ; et/ou
ledit filtre (118) comprenant un filtre passe-bas conçu pour limiter la bande passante du signal numérique afin de comprendre uniquement la première pente et la crête du signal numérique ; et/ou
ledit filtre (118) comprenant un filtre extrait conçu pour façonner de nouveau une réponse en fréquence du canal particulier de l'instrument d'essai et de mesure en une réponse plate.

7. Filtre de bruit selon l'une quelconque des revendications 1 à 6, ledit signal étant un signal positif d'une paire de signaux différentiels, ledit diviseur étant un premier diviseur, ledit combineur étant un premier combineur et ledit signal combiné étant un premier signal combiné, le filtre de bruit comprenant en outre :

un second diviseur conçu pour recevoir un signal négatif de la paire de signaux différentiels et diviser le signal négatif en au moins un troisième signal divisé et un quatrième signal divisé ;
un troisième chemin conçu pour recevoir le troisième signal divisé, le troisième chemin comprenant : un second atténuateur variable et une second ligne à retard variable ;
un quatrième chemin conçu pour recevoir le quatrième signal divisé ;

17

un deuxième combineur conçu pour combiner un signal provenant du deuxième chemin et un signal provenant du troisième chemin en un deuxième signal combiné ; et

un troisième combineur conçu pour combiner le premier signal combiné et le deuxième signal combiné en un troisième signal combiné.

**8.** Filtre de bruit selon la revendication 7, ledit deuxième chemin et ledit quatrième chemin comprenant une ligne à retard fixe ; et/ou

au moins l'un du premier atténuateur variable, de la première ligne à retard variable, du second atténuateur variable et de la seconde ligne à retard variable étant réglés par un dispositif de commande.

**9.** Filtre de bruit selon la revendication 7 ou 8, au moins l'un du premier atténuateur variable et du second atténuateur variable comprenant :

une pluralité d'atténuateurs, chaque atténuateur possédant une valeur d'atténuation différente ; et
une pluralité de commutateurs,
ledit au moins un parmi le premier atténuateur variable et le second atténuateur variable étant réglé en commutant l'un de la pluralité d'atténuateurs dans le premier chemin ; et/ou
au moins l'une de la première ligne à retard variable et du second retard variable comprenant :

une pluralité de lignes à retard, chaque ligne à retard possédant une quantité de retard différente ; et une pluralité de commutateurs,
au moins l'un de la première ligne à retard variable et du second retard variable étant réglé en commutant l'une de la pluralité de lignes à retard dans le premier chemin.

**10.** Filtre de bruit selon l'une quelconque des revendications 7 à 9, ledit troisième combineur étant un balun possédant une entrée inversée et une entrée non inversée ; et/ou

au moins l'un du premier combineur, du deuxième combineur et du troisième combineur étant un multiplexeur.

**11.** Filtre de bruit selon l'une quelconque des revendications 7 à 10, comprenant en outre :

un convertisseur analogique-numérique conçu pour recevoir le troisième signal combiné et délivrer en sortie un signal numérique représentant le troisième signal combiné ; et
un filtre configuré pour recevoir le signal numérique et délivrer en sortie un signal numérique filtré ;
et/ou
chacun des premier et deuxième signaux divisés comprenant sensiblement la totalité de la bande passante du signal positif, et chacun des troisième et quatrième signaux comprenant sensiblement la totalité de la bande passante du signal négatif.

**12.** Filtre de bruit selon l'une quelconque des revendications 7 à 11,

ledit premier diviseur étant un premier multiplexeur et ledit deuxième diviseur étant un second multiplexeur, et
ledit premier signal divisé comprenant une première bande passante du signal positif et ledit deuxième signal divisé comprenant une deuxième bande passante du signal positif, la première bande passante et la deuxième bande passante étant différentes l'une de l'autre, et
ledit troisième signal divisé comprenant une troisième bande passante du signal négatif et ledit quatrième signal divisé comprenant une quatrième bande passante du signal négatif, la troisième bande passante et la quatrième bande passante étant différentes l'une de l'autre.

**13.** Procédé permettant de réduire le bruit ajouté par un canal particulier d'un instrument d'essai et de mesure, le procédé comprenant :

la division d'un signal en au moins un premier signal divisé et un deuxième signal divisé ; la définition d'une quantité d'atténuation pour un atténuateur variable (108) ; la définition d'une quantité de retard pour une ligne à retard variable (110) ;
l'atténuation du premier signal divisé de la quantité d'atténuation à travers l'atténuateur variable (108) ;
le retard du premier signal divisé atténué de la quantité de retard à travers la ligne à retard variable (110) ;
la combinaison du premier signal divisé retardé et atténué et du deuxième signal divisé en un signal combiné ;
la conversion du signal combiné en un signal numérique représentant le signal combiné ; et

le filtrage du signal numérique pour délivrer en sortie un signal numérique filtré ;
au moins l'une de la quantité d'atténuation ou de la quantité de retard étant définie sur la base du canal particulier de l'instrument d'essai et de mesure.

14. Procédé selon la revendication 13, comprenant en outre le retard du deuxième signal divisé à travers une ligne à retard fixe avant de combiner le deuxième signal divisé et le premier signal divisé retardé et atténué ; et/ou

ladite définition de la quantité d'atténuation pour l'atténuateur variable comprenant la commutation dans l'un d'une pluralité d'atténuateurs différents ; et/ou
ladite définition de la quantité de retard pour la ligne à retard variable comprenant la commutation dans l'une d'une pluralité de lignes à retard différentes.

15. Procédé selon la revendication 13 ou 14, ledit signal étant un premier signal, le procédé comprenant en outre la division d'un signal d'entrée en un signal de bande haute fréquence et un signal de bande basse fréquence, ledit premier signal étant le signal de bande basse fréquence, et ledit signal combiné étant un premier signal combiné, et ledit procédé comprenant en outre la combinaison du premier signal combiné et du signal de bande haute fréquence en un deuxième signal combiné ; et/ou
ledit filtrage du signal numérique comprenant :

le filtrage le signal numérique pour correspondre à une réponse de forme d'égaliseur linéaire à temps continu spécifique ; et/ou
le filtrage du signal numérique pour limiter la bande passante afin de comprendre uniquement la première pente et la crête du signal numérique ; et/ou
le filtrage du signal numérique pour façonner de nouveau la réponse en fréquence du canal particulier de l'instrument d'essai et de mesure en une réponse plate.

**FIG. 1**

EP 3 521 836 B1

**FIG. 2**

EP 3 521 836 B1

300

Input

302

| Low |
| --- |
| Mux |
| High |

104

Splitter

106

Fixed Delay Line

108

Variable Attenuator

110

Variable Delay Line

112

Controller

114

+ Combiner −

304

| Low |
| --- |
| Mux |
| High |

116

ADC

118

Filter

Output

**FIG. 3**

FIG. 4

FIG. 5

**FIG. 6**

EP 3 521 836 B1

EP 3 521 836 B1

Input → DC Block → Wilkinson Splitter -3dB

Fixed Delay Line → Balun -6dB (+/-) → A/D → Lowpass Plus De-embed or Lowpass Plus Target CTLE Correction → Output

Variable Attenuator → Variable Delay Line

Manual or Computer Control Setup

700

# FIGURE 7

**FIGURE 8**

Output

Lowpass
Plus
De-embed
or
Lowpass
Plus
Target CTLE
Correction

A/D

Differential
Amplifier

900

Fixed
Delay
Line

Variable
Delay
Line

Variable
Attenuator

Manual or Computer
Control Setup

Wilkinson
Splitter
-3dB

DC Block

Input

**FIGURE 9**

28

EP 3 521 836 B1

**FIGURE 10**

**FIGURE 11**

**FIGURE 12**

**FIGURE 13**

FIGURE 14

delay in ps:    $t = 1 \times 10^{-10}$    CTLE response peak:    $fp = 5 \times 10^9$

Attenuator dB shown in legend

**FIGURE 15**

delay in ps:    $t = 3.333 \times 10^{-11}$    CTLE response peak:    $fp = 1.5 \times 10^{10}$

Attenuator dB shown in legend

**FIGURE 16**

delay in ps:    $t = 1.429 \times 10^{-11}$        CTLE response peak:    $fp = 3.5 \times 10^{10}$

Attenuator dB shown in legend

FIGURE 17

delay in ps:    $t = 1.111 \times 10^{-11}$        CTLE response peak:    $fp = 4.5 \times 10^{10}$

Attenuator dB shown in legend

FIGURE 18

35

**EP 3 521 836 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009002213 A
- US 2006080065 A